# EUROPEAN PATENT APPLICATION

(11) **EP 4 036 648 A1**
(43) Date of publication of application: **03.08.2022**
(21) Application number: 20867611.4
(22) Date of filing: 24.06.2020
(51) Int. Cl.: G03F 7/42, C11D 1/00, C11D 3/20, C11D 11/00, G03F 7/26, G03F 7/30, G03F 7/40, G03F 7/16, G03F 7/20

(54) **PROCESS LIQUID COMPOSITION FOR PHOTOLITHOGRAPHY AND PATTERN FORMING METHOD USING SAME**

(30) Priority: 26.09.2019 KR 20190118885
(71) Applicant: Young Chang Chemical Co., Ltd., Seongju-gun, Gyeongsangbuk-do 40046 (KR)
(72) Inventor: LEE, Su Jin, Daegu 42634 (KR); KIM, Gi Hong, Daegu 41808 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2020/008142
(87) International publication number: WO 2021/060672

(57) **Abstract**

The present invention relates to a process liquid composition for moving a lifting defect level of a photoresist pattern having hydrophobicity represented by a contact angle of 75° or larger of a photoresist surface with respect to water in a photoresist patterning process, and a preparation method thereof. The process liquid composition includes 0.00001% to 0.1% by weight of a fluorine-based surfactant, 0.00001% to 1.0% by weight of a triol derivative, a tetraol derivative, or a mixture thereof, and the remaining proportion of water. The process liquid composition has a surface tension of 45 mN/m or less and a contact angle of 65° or smaller.

## Description

### Technical Field

The present invention relates to a process liquid composition for alleviating a lifting defect level of a photoresist pattern, the photoresist pattern having hydrophobicity represented by a contact angle of 75° or greater of a surface thereof with respect to water in a photoresist patterning process, and to a method of forming a photoresist pattern using the process liquid composition.

### Background Art

Generally, a semiconductor device is manufactured by a lithographic process in which exposure light is infrared light with a wavelength of 193 nm, 248 nm, 365 nm, or the like. There is intense competition among semiconductor device manufacturers for reduction in a critical dimension (hereinafter referred to as a CD).

Accordingly, a light source creating a shorter wavelength is required to form a finer pattern. At the present time, a lithographic technology using extreme ultraviolet rays (EUV in a wavelength of 13.5 nm) is actively employed. A narrower wavelength may be realized using this lithographic technology.

However, the resistance of EUV photoresist to etching is not yet improved, and thus a photoresist pattern having a high aspect ratio still needs to be used. Accordingly, a pattern lifting defect occurs easily during development. Consequently, a process margin is greatly reduced in a manufacturing process.

To solve this problem, there is a demand to develop the technology for alleviating a level of a lifting defect that occurs while forming a fine pattern. The best way to alleviate a pattern lifting defect level may be to improve photoresist performance. However, there is a need to consider a situation where, in practice, it is difficult to develop new photoresist having performance that is satisfactory in terms of all aspects.

There is still a need to develop new photoresists. However, attempts have been made to alleviate the pattern lifting defect level in ways other than the development of new photoresist.

### Disclosure

### Technical Problem

The objective of the present invention is to develop a process liquid composition for alleviating a level of a pattern lifting defect occurring after developing photoresist having hydrophobicity represented by a contact angle of 75° or a surface thereof with respect to water, and to develop a method of forming a photoresist pattern using the process liquid composition.

### Technical Solution

Various surfactants are used to manufacture a water-based process liquid composition that is used during a developing process. However, according to the present invention, an effective process liquid composition was manufactured using a fluorine-based surfactant.

The use of a hydrocarbon-based surfactant with a property like hydrophobicity in manufacturing the water-based process liquid composition in which ultra-pure water is mostly contained may lead to forming a hydrophobic sidewall of a photoresist, thereby reducing pattern melting or collapse. However, in this case, the hydrocarbon-based surfactants have a strong tendency to agglomerate, resulting in preventing a property of the process liquid composition from being uniform. Theretofore, there is a likelihood that the agglomerating hydrocarbon-based surfactants will cause defects while the process liquid composition is in use. That is, the use of the hydrocarbon-based surfactant requires an increase in the usage amount thereof for reducing the pattern melting. Thus, there is a concern that photoresist will be damaged. In addition, the excessive use of an unsuitable surfactant for the purpose of reducing surface tension of the process liquid composition to reduce a capillary force may lead to the pattern melting and rather may further cause the pattern collapse.

According to the present invention, it was verified that the use of a fluorine-based surfactant and an additional substance selected from triol derivatives, tetraol derivatives, and mixtures thereof achieved the noticeable effect of alleviating a pattern lifting defect level. The surface tension and contact angle, which were much more decreased than in the hydrocarbon-based surfactant, increased penetrability and spreadability, leading to contribution to formation of a fine pattern.

As a representative developing liquid that is currently used in most of the photolithographic developing processes, tetramethylammonium hydroxide diluted with pure water in the ratio that 2.38% by weight of tetramethylammonium hydroxide is mixed with 97.62% by weight of water is used.

It was verified that a pattern lifting defect was caused in a case where, in a photolithographic process, a photoresist pattern having hydrophobicity represented by a contact angle of 75° or greater of a surface thereof with respect to water was successively cleaned only with pure water after being developed. Furthermore, it was verified that, in a photolithographic process, a pattern collapse was also caused in a case where a process liquid composition resulting from tetramethylammonium hydroxide being contained in pure water was successively applied after developing or in a case where pure water was successively applied after developing and then the diluted tetramethylammonium hydroxide was applied thereafter.

It could be inferred that the pattern collapse was caused because the process liquid composition containing tetramethylammonium hydroxide weakened the exposed fine pattern and because the capillary force was great or non-uniform.

Therefore, in order to prevent the exposed-pattern collapse and to reduce the line width roughness (LWR) and the number of defects, there is a need to conduct study on a substance that exerts a relatively weaker force on the exposed pattern than tetramethylammonium hydroxide.

According to the present invention, it was verified that, in a case where a fluorine-based surfactant is used and a substance selected from triol derivatives, tetraol derivatives, and mixtures thereof is additionally used, the pattern collapse was prevented and the LWR and/or the number of defects was also reduced.

According to a desirable first embodiment of the present invention, there is provided a process liquid composition for alleviating a level of a lifting defect of a photoresist pattern, the lifting defect occurring during photoresist developing, the composition containing: 0.00001% to 0.1% by weight of a fluorine-based surfactant; 0.00001% to 1.0% by weight of a substance selected from the group consisting of triol derivatives, tetraol derivatives, and mixtures thereof; and the remaining proportion of water, in which the composition has a surface tension of 45 millinewton/meter (mN/m = 1/1000 newton/meter) or less and a contact angle of 65° or smaller.

According to a more desirable second embodiment of the present invention, there is provided a process liquid composition for alleviating a level of a lifting defect of a photoresist pattern, the lifting defect occurring during photoresist developing, the composition containing: 0.0001% to 0.1% by weight of a fluorine-based surfactant; 0.00001% to 1.0% by weight of a substance selected from the group consisting of triol derivatives, tetraol derivatives, and mixtures thereof; and the remaining proportion of water, in which the composition has a surface tension of 45 mN/m or less and a contact angle of 65° or smaller.

According to a further desirable third embodiment of the present invention, there is provided a process liquid composition for alleviating a level of a lifting defect of a photoresist pattern, the lifting defect occurring during photoresist developing, the composition containing: 0.001% to 0.1% by weight of a fluorine-based surfactant; 0.00001% to 1.0% by weight of a substance selected from the group consisting of triol derivatives, tetraol derivatives, and mixtures thereof; and the remaining proportion of water, in which the liquid has a surface tension of 45 mN/m or less and a contact angle of 65° or smaller.

According to a most desirable fourth embodiment of the present invention, there is provided a process liquid composition for alleviating a level of a lifting defect of a photoresist pattern, the lifting defect occurring during photoresist developing, the composition containing: 0.001% to 0.1% by weight of a fluorine-based surfactant; 0.0001% to 1.0% by weight of a substance selected from the group consisting of triol derivatives, tetraol derivatives, and mixtures thereof; and the remaining proportion of water, in which the composition has a surface tension of 45 mN/m or less and a contact angle of 65° or smaller.

According to a most desirable fifth embodiment of the present invention, there is provided a process liquid composition for alleviating a level of a lifting defect of a photoresist pattern, the lifting defect occurring during photoresist developing, the composition containing: 0.001% to 0.1% by weight of a fluorine-based surfactant; 0.001% to 1.0% by weight of a substance selected from the group consisting of triol derivatives, tetraol derivatives, and mixtures thereof; and the remaining proportion of water, in which the liquid has a surface tension of 45 mN/m or less and a contact angle of 65° or smaller.

In the embodiments, the fluorine-based surfactant may be selected from the group consisting of fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, perfluorianted sulfonate, and mixtures thereof.

In the embodiments, the triol derivative may be a C3 to C10 triol and may be selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene -1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof.

In the embodiments, the tetraol derivative may be a C4 to C14 tetraol and may be selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2, 5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

According to an aspect of the present invention, there is provided a method of forming a photoresist pattern, the method including the steps of: (a) applying photoresist on a semiconductor substrate to form a photoresist film; (b) exposing the photoresist film to light and developing the photoresist film to form a photoresist pattern; and (c) cleaning the photoresist pattern with the process liquid composition.

It was thought that the pattern collapse was caused by the capillary force occurring between patterns when the patterns were cleaned with pure water after developing. However, it was experimentally recognized that only the reduction of the capillary force could neither completely prevent the pattern collapse nor reduce the number of the lifting defects.

The excessive use of the unsuitable surfactant for the purpose of reducing the surface tension of the process liquid composition to reduce the capillary force may lead to the pattern melting, resulting in an increase in the level of the pattern lifting defect.

In order to alleviate the level of the pattern lifting defect, it is important to select a surfactant that reduces the surface tension of the process liquid composition and at the same time to prevent the melting of the photoresist pattern.

The process liquid composition according to the present invention exerts an enhancing effect on photoresist and particularly achieves the effect of alleviating the level of the pattern lifting defect occurring while developing the photoresist having hydrophobicity represented by a contact angle of 75° or greater of a surface thereof with respect to water.

### Advantageous Effects

The process liquid composition according to the present invention achieves the effect of alleviating the level of the pattern lifting defect, the effect being unable to be achieved when only photoresist is used along to form a photoresist pattern having hydrophobicity represented by a contact angle of 75°C or greater of a surface thereof with respect to water. The photoresist forming method including the step of cleaning the photoresist pattern with the process liquid composition can achieve the effect of greatly reducing manufacturing cost.

### Best Mode

Hereinafter, the present invention will be described in detail.

The present invention, which is the result of conducting much research over a long period of time, relates to a "process liquid composition for alleviating a lifting defect level of a photoresist pattern, the process liquid composition including: 0.00001% to 0.1% by weight of a fluorine-based surfactant; 0.00001% to 1.0% by weight of a C3 to C10 triol derivative alone, a C4 to C14 tetraol derivative alone, or a mixture of the C3 to C10 triol derivative and the C4 to C14 tetraol derivative; and the remaining proportion of water. Herein, the fluorine-based surfactant is selected from the group consisting of fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, perfluorianted sulfonate, and mixtures thereof. In addition, the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof. In addition, the tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof. Composition components of the process liquid composition according to the present invention and a composition ratio among the components thereof were specified as shown in Examples 1 to 80. Composition components and ratios that were in contrast with the above-mentioned composition components and ratios, respectively, are specified as shown in Comparative Examples 1 to 13.

Herein after, the preferred examples of the invention and comparative examples will be described. However, the preferred examples described below are presented only for illustrative purposes and are not intended to limit the present invention.

### Mode for Carrying out the Invention

### [Example 1]

A process liquid composition for alleviating a collapse level of a photoresist pattern which contains 0.001% by weight of fluoroacryl carboxylate and 0.01% by weight of 1,2,3-propanetriol was prepared using the following method.

0.001% By weight of fluoroacryl carboxylate and 0.01% by weight of 1,2,3-propanetriol were added into the remaining proportion of distilled water and stirred for 5 hours. Then, the resulting liquid was filtered through a 0.01 µm filter to remove fine solid impurities. In this manner, the process liquid composition for alleviating the collapse level of the photoresist pattern was prepared.

### [Example 2 to Example 80]

Process liquid compositions for alleviating a defect level of the same photoresist pattern as in Example 1 were prepared according to composition components and ratios that were specified as shown in Tables 1 to 15.

### [Comparative Example 1]

Distilled water that was used as a cleaning liquid in the last process among typical semiconductor manufacturing processes was prepared.

### [Comparative Example 2 to Comparative Example 13]

For comparison with Examples, process liquid compositions were prepared in the same manner as in Example 1, according to the composition components and ratios that were specified as shown in Tables 1 to 15.

[Experimental Examples 1 to 80 and Comparative Experimental Examples 1 to 13]

Measurements of pattern lifting defect levels were performed on silicon wafers on which patterns were formed using the compositions prepared in Examples 1 to 80 and Comparative Examples 1 to 13. The measurements are described as Experimental Examples 1 to 80 and Comparative Experimental Examples 1 to 13. The results of the measurements are shown in Table 16.

### (1) Verification of Pattern Lifting Prevention

After exposure energy and focus were split, among a total of 89 blocks, the number of blocks in which a pattern did not collapse was detected using a critical dimension-scanning electron microscope (CD-SEM, manufactured by Hitachi, Ltd).

### (2) Transparency

Transparency of each of the prepared process liquid composition was checked with the naked eye and was marked as a transparent or opaque process liquid composition.

### (3) Surface Tension and Contact Angle

The surface tension and contact angle of each of the process liquid compositions were measured using a surface tension measuring instrument [the K-100 Force Tensiometer manufactured by KRÜSS GmbH] and a contact angle measuring instrument [the DSA-100 Drop Shape Analyzer manufactured by KRÜSS GmbH].

**[Table 1]**

| | Surfactant | | Additive | | Distilled water | |
|---|---|---|---|---|---|---|
| | Name | Content (% by weight) | Name | Content (% by weight) | Name | Content (% by weight) |
| Example 1 | Fluoroacrylic carboxylate | 0.001 | 1,2,3-propanetriol | 0.01 | Distilled water | 99.9890 |
| Example 2 | Fluoroalkyl ether | 0.001 | 1,2,3-propanetriol | 0.01 | Distilled water | 99.9890 |
| Example 3 | Fluoroalkylene ether | 0.001 | 1,2,3-propanetriol | 0.01 | Distilled water | 99.9890 |
| Example 4 | Fluoroalkyl sulfate | 0.001 | 1,2,3-propanetriol | 0.01 | Distilled water | 99.9890 |
| Example 5 | Fluoroalkyl phosphate | 0.001 | 1,2,3-propanetriol | 0.01 | Distilled water | 99.9890 |
| Example 6 | Fluoroacrylic copolymer | 0.001 | 1,2,3-propanetriol | 0.01 | Distilled water | 99.9890 |
| Example 7 | Fluorine copolymer | 0.001 | 1,2,3-propanetriol | 0.01 | Distilled water | 99.9890 |
| Example 8 | Perfluoric acid | 0.001 | 1,2,3-propanetriol | 0.01 | Distilled water | 99.9890 |
| Example 9 | Per fluorinated carboxyl salts | 0.001 | 1,2,3-propanetriol | 0.01 | Distilled water | 99.9890 |
| Example 10 | Per fluorinated sulfonate | 0.001 | 1,2,3-propanetriol | 0.01 | Distilled water | 99.9890 |
| Comparative Example 1 | - | - | - | - | Distille d water | 100 |

**[Table 2]**

| | Surfactant | | Additive | | Distilled water | |
|---|---|---|---|---|---|---|
| | Name | Content (% by weight) | Name | Content (% by weight) | Name | Content (% by weight) |
| Example 11 | Fluoroacrylic carboxylate | 0.001 | 1,2,3,4-Butanetetraol | 0.01 | Distilled water | 99.9890 |
| Example 12 | Fluoroalkyl ether | 0.001 | 1,2,3,4-Butanetetraol | 0.01 | Distilled water | 99.9890 |
| Example 13 | Fluoroalkylene ether | 0.001 | 1,2,3,4-Butanetetraol | 0.01 | Distilled water | 99.9890 |
| Example 14 | Fluoroalkyl sulfate | 0.001 | 1,2,3,4-Butanetetraol | 0.01 | Distilled water | 99.9890 |
| Example 15 | Fluoroalkyl phosphate | 0.001 | 1,2,3,4-Butanetetraol | 0.01 | Distilled water | 99.9890 |
| Example 16 | Fluoroacrylic copolymer | 0.001 | 1,2,3,4-Butanetetraol | 0.01 | Distilled water | 99.9890 |
| Example 17 | Fluorine copolymer | 0.001 | 1,2,3,4-Butanetetraol | 0.01 | Distilled water | 99.9890 |
| Example 18 | Perfluoric acid | 0.001 | 1,2,3,4-Butanetetraol | 0.01 | Distilled water | 99.9890 |
| Example 19 | Perfluorinated carboxyl salts | 0.001 | 1,2,3,4-Butanetetraol | 0.01 | Distilled water | 99.9890 |
| Example 20 | Perfluorinated sulfonate | 0.001 | 1,2,3,4-Butanetetraol | 0.01 | Distilled water | 99.9890 |

**[Table 3]**

| | Surfactant | | Additive | | Distilled water | |
|---|---|---|---|---|---|---|
| | Name | Content (% by weight) | Name | Content (% by weight) | Name | Content (% by weight) |
| Example 21 | Fluoroacrylic carboxylate | 0.0000 1 | 1,2,3-propanetriol | 0.01 | Distilled water | 99.98999 |
| Example 22 | Fluoroacrylic carboxylate | 0.0001 | 1,2,3-propanetriol | 0.01 | Distilled water | 99.9899 |
| Example 1 | Fluoroacrylic carboxylate | 0.001 | 1,2,3-propanetriol | 0.01 | Distilled water | 99.9890 |
| Example 23 | Fluoroacrylic carboxylate | 0.01 | 1,2,3-propanetriol | 0.01 | Distilled water | 99.9800 |
| Example 24 | Fluoroacrylic carboxylate | 0.1 | 1,2,3-propanetriol | 0.01 | Distilled water | 99.8900 |
| Comparative Example 2 | Fluoroacrylic carboxylate | 1 | 1,2,3-propanetriol | 0.01 | Distilled water | 98.9900 |

**[Table 4]**

| | Surfactant | | Additive | | Distilled water | |
|---|---|---|---|---|---|---|
| | Name | Conten by (% weight) | Name | Content (% by weight) | Name | Content (% by weight) |
| Example 25 | Fluoroalkyl ether | 0.0000 1 | 1,2,3-propanetriol | 0.01 | Distilled water | 99.98999 |
| Example 26 | Fluoroalkyl ether | 0.0001 | 1,2,3-propanetriol | 0.01 | Distilled water | 99.9899 |
| Example 2 | Fluoroalkyl ether | 0.001 | 1,2,3-propanetriol | 0.01 | Distilled water | 99.9890 |
| Example 27 | Fluoroalkyl ether | 0.01 | 1,2,3-propanetriol | 0.01 | Distilled water | 99.9800 |
| Example 28 | Fluoroalkyl ether | 0.1 | 1,2,3-propanetriol | 0.01 | Distilled water | 99.8900 |
| Comparative Example 3 | Fluoroalkyl ether | 1 | 1,2,3-propanetriol | 0.01 | Distilled water | 98.9900 |

**[Table 5]**

| | Surfactant | | Additive | | Distilled water | |
|---|---|---|---|---|---|---|
| | Name | Content (% by weight) | Name | Content (% by weight) | Name | Content (% by weight) |
| Example 29 | Fluoroalkylene ether | 0.00001 | 1,2,3-propanetriol | 0.01 | Distilled water | 99.98999 |
| Example 30 | Fluoroalkylene ether | 0.0001 | 1,2,3-propanetriol | 0.01 | Distilled water | 99.9899 |
| Example 3 | Fluoroalkylene ether | 0.001 | 1,2,3-propanetriol | 0.01 | Distilled water | 99.9890 |
| Example 31 | Fluoroalkylene ether | 0.01 | 1,2,3-propanetriol | 0.01 | Distilled water | 99.9800 |
| Example 32 | Fluoroalkylene ether | 0.1 | 1,2,3-propanetriol | 0.01 | Distilled water | 99.8900 |
| Comparative Example 4 | Fluoroalkylene ether | 1 | 1,2,3-propanetriol | 0.01 | Distilled water | 98.9900 |

**[Table 6]**

| | Surfactant | | Additive | | Distilled water | |
|---|---|---|---|---|---|---|
| | Name | Conten by (% weight ) | Name | Conten by (% weight ) | Name | Content (% by weight) |
| Example 33 | Fluoroalkyl sulfate | 0.0000 1 | 1,2,3-propanetrio 1 | 0.01 | Distille d water | 99.9899 9 |
| Example 34 | Fluoroalkyl sulfate | 0.0001 | 1,2,3-propanetrio 1 | 0.01 | Distille d water | 99.9899 |
| Example 4 | Fluoroalkyl sulfate | 0.001 | 1,2,3-propanetrio 1 | 0.01 | Distille d water | 99.9890 |
| Example 35 | Fluoroalkyl sulfate | 0.01 | 1,2,3-propanetrio 1 | 0.01 | Distille d water | 99.9800 |
| Example 36 | Fluoroalkyl sulfate | 0.1 | 1,2,3-propanetrio 1 | 0.01 | Distille d water | 99.8900 |
| Comparative Example 5 | Fluoroalkyl sulfate | 1 | 1,2,3-propanetrio 1 | 0.01 | Distille d water | 98.9900 |

**[Table 7]**

| | Surfactant | | Additive | | Distilled water | |
|---|---|---|---|---|---|---|
| | Name | Content (% by weight) | Name | Content (% by weight) | Name | Content (% by weight) |
| Example 37 | Fluoroalkyl phosphate | 0.0000 1 | 1,2,3-propanetriol | 0.01 | Distilled water | 99.98999 |
| Example 38 | Fluoroalkyl phosphate | 0.0001 | 1,2,3-propanetriol | 0.01 | Distilled water | 99.9899 |
| Example 5 | Fluoroalkyl phosphate | 0.001 | 1,2,3-propanetriol | 0.01 | Distilled water | 99.9890 |
| Example 39 | Fluoroalkyl phosphate | 0.01 | 1,2,3-propanetriol | 0.01 | Distilled water | 99.9800 |
| Example 40 | Fluoroalkyl phosphate | 0.1 | 1,2,3-propanetriol | 0.01 | Distilled water | 99.8900 |
| Comparative Example 6 | Fluoroalkyl phosphate | 1 | 1,2,3-propanetriol | 0.01 | Distilled water | 98.9900 |

**[Table 8]**

| | Surfactant | | Additive | | Distilled water | |
|---|---|---|---|---|---|---|
| | Name | Content (% by weight) | Name | Content by (% weight) | Name | Content (% by weight) |
| Example 41 | Fluoroacrylic copolymer | 0.0000 1 | 1,2,3-propanetriol | 0.01 | Distilled water | 99.98999 |
| Example 42 | Fluoroacrylic copolymer | 0.0001 | 1,2,3-propanetriol | 0.01 | Distilled water | 99.9899 |
| Example 6 | Fluoroacrylic copolymer | 0.001 | 1,2,3-propanetriol | 0.01 | Distilled water | 99.9890 |
| Example 43 | Fluoroacrylic copolymer | 0.01 | 1,2,3-propanetriol | 0.01 | Distille d water | 99.9800 |
| Example 44 | Fluoroacrylic copolymer | 0.1 | 1,2,3-propanetriol | 0.01 | Distille d water | 99.8900 |
| Comparative Example 7 | Fluoroacrylic copolymer | 1 | 1,2,3-propanetriol | 0.01 | Distille d water | 98.9900 |

**[Table 9]**

| | Surfactant | | Additive | | Distilled water | |
|---|---|---|---|---|---|---|
| | Name | Content (% by weight) | Name | Content (% by weight) | Name | Content (% by weight) |
| Example 45 | Fluorine copolymer | 0.00001 | 1,2,3-propanetriol | 0.01 | Distilled water | 99.98999 |
| Example 46 | Fluorine copolymer | 0.0001 | 1,2,3-propanetriol | 0.01 | Distilled water | 99.9899 |
| Example 7 | Fluorine copolymer | 0.001 | 1,2,3-propanetriol | 0.01 | Distilled water | 99.9890 |
| Example 47 | Fluorine copolymer | 0.01 | 1,2,3-propanetriol | 0.01 | Distilled water | 99.9800 |
| Example 48 | Fluorine copolymer | 0.1 | 1,2,3-propanetriol | 0.01 | Distilled water | 99.8900 |
| Comparative Example 8 | Fluorine copolymer | 1 | 1,2,3-propanetriol | 0.01 | Distilled water | 98.9900 |

**[Table 10]**

| | Surfactant | | Additive | | Distilled water | |
|---|---|---|---|---|---|---|
| | Name | Content (% by weight) | Name | Content (% by weight) | Name | Content (% by weight) |
| Example 49 | Perfluoric acid | 0.00001 | 1,2,3-propanetriol | 0.01 | Distilled water | 99.98999 |
| Example 50 | Perfluoric acid | 0.0001 | 1,2,3-propanetriol | 0.01 | Distilled water | 99.9899 |
| Example 8 | Perfluoric acid | 0.001 | 1,2,3-propanetriol | 0.01 | Distilled water | 99.9890 |
| Example 51 | Perfluoric acid | 0.01 | 1,2,3-propanetriol | 0.01 | Distilled water | 99.9800 |
| Example 52 | Perfluoric acid | 0.1 | 1,2,3-propanetriol | 0.01 | Distilled water | 99.8900 |
| Comparative Example 9 | Perfluoric acid | 1 | 1,2,3-propanetriol | 0.01 | Distilled water | 98.9900 |

**[Table 11]**

| | Surfactant | | Additive | | Distilled water | |
|---|---|---|---|---|---|---|
| | Name | Content (% by weight) | Name | Content (% by weight) | Name | Content (% by weight) |
| Example 53 | Per fluorinated carboxyl salts | 0.0000 1 | 1,2,3-propanetriol | 0.01 | Distilled water | 99.98999 |
| Example 54 | Per fluorinated carboxyl salts | 0.0001 | 1,2,3-propanetriol | 0.01 | Distilled water | 99.9899 |
| Example 9 | Per fluorinated carboxyl salts | 0.001 | 1,2,3-propanetriol | 0.01 | Distilled water | 99.9890 |
| Example 55 | Per fluorinated carboxyl salts | 0.01 | 1,2,3-propanetriol | 0.01 | Distilled water | 99.9800 |
| Example 56 | Per fluorinated carboxyl salts | 0.1 | 1,2,3-propanetriol | 0.01 | Distilled water | 99.8900 |
| Comparative Example 10 | Per fluorinated carboxyl salts | 1 | 1,2,3-propanetriol | 0.01 | Distilled water | 98.9900 |

**[Table 12]**

| | Surfactant | | Additive | | Distilled water | |
|---|---|---|---|---|---|---|
| | Name | Conten t (% by weight ) | Name | Conten t (% by weight ) | Name | Content (% by weight) |
| Example 57 | Per fluorinated sulfonate | 0.00001 | 1,2,3-propanetriol | 0.01 | Distilled water | 99.98999 |
| Example 58 | Per fluorinated sulfonate | 0.0001 | 1,2,3-propanetriol | 0.01 | Distilled water | 99.9899 |
| Example 10 | Per fluorinated sulfonate | 0.001 | 1,2,3-propanetriol | 0.01 | Distilled water | 99.9890 |
| Example 59 | Per fluorinated sulfonate | 0.01 | 1,2,3-propanetriol | 0.01 | Distilled water | 99.9800 |
| Example 60 | Per fluorinated sulfonate | 0.1 | 1,2,3-propanetriol | 0.01 | Distilled water | 99.8900 |
| Comparativ e Example 11 | Per fluorinated sulfonate | 1 | 1,2,3-propanetriol | 0.01 | Distilled water | 98.9900 |

**[Table 13]**

| | Surfactant | | Additive | | Additive | | Distilled water | |
|---|---|---|---|---|---|---|---|---|
| | Name | Content (% by weight) | Name | Content (% by weight) | Name | Content (% by weight) | Name | Content (% by weight) |
| Example 61 | Fluoroacrylic carboxylat e | 0.001 | 1,2,3-propanetriol | 0.005 | 1,2,3,4-Butanetetraol | 0.005 | Distilled water | 99.9890 |
| Example 62 | Fluoroalkyl ether | 0.001 | 1,2,3-propanetriol | 0.005 | 1,2,3,4-Butanetetraol | 0.005 | Distilled water | 99.9890 |
| Example 63 | Fluoroalkylene ether | 0.001 | 1,2,3-propanetriol | 0.005 | 1,2,3,4-Butanetetraol | 0.005 | Distilled water | 99.9890 |
| Example 64 | Fluoroalkyl sulfate | 0.001 | 1,2,3-propanetriol | 0.005 | 1,2,3,4-Butanetetraol | 0.005 | Distilled water | 99.9890 |
| Example 65 | Fluoroalkyl phosphate | 0.001 | 1,2,3-propanetriol | 0.005 | 1,2,3,4-Butanetetraol | 0.005 | Distilled water | 99.9890 |
| Example 66 | Fluoroacrylic copolymer | 0.001 | 1,2,3-propanetriol | 0.005 | 1,2,3,4-Butanetetraol | 0.005 | Distilled water | 99.9890 |
| Example 67 | Fluorine copolymer | 0.001 | 1,2,3-propanetriol | 0.005 | 1,2,3,4-Butanetetraol | 0.005 | Distilled water | 99.9890 |
| Example 68 | Perfluoric acid | 0.001 | 1,2,3-propanetriol | 0.005 | 1,2,3,4-Butanetetraol | 0.005 | Distilled water | 99.9890 |
| Example 69 | Perfluorinated carboxyl salts | 0.001 | 1,2,3-propanetriol | 0.005 | 1,2,3,4-Butanetetraol | 0.005 | Distilled water | 99.9890 |
| Example 70 | Perfluorinated sulfonate | 0.001 | 1,2,3-propanetriol | 0.005 | 1,2,3,4-Butanetetraol | 0.005 | Distilled water | 99.9890 |

**[Table 14]**

| | Surfactant | | Additive | | Distilled water | |
|---|---|---|---|---|---|---|
| | Name | Content (% by weight) | Name | Content (% by weight) | Name | Content (% by weight) |
| Example 71 | Fluoroacrylic carboxylate | 0.001 | 1,2,3-propanetriol | 0.0000 1 | Distilled water | 99.99899 |
| Example 72 | Fluoroacrylic carboxylate | 0.001 | 1,2,3-propanetriol | 0.0001 | Distilled water | 99.9989 |
| Example 73 | Fluoroacrylic carboxylate | 0.001 | 1,2,3-propanetriol | 0.001 | Distilled water | 99.9980 |
| Example 1 | Fluoroacrylic carboxylate | 0.001 | 1,2,3-propanetriol | 0.01 | Distilled water | 99.9890 |
| Example 74 | Fluoroacrylic carboxylate | 0.001 | 1,2,3-propanetriol | 0.1 | Distilled water | 99.8990 |
| Example 75 | Fluoroacryli c carboxylate | 0.001 | 1,2,3-propanetriol | 1.0 | Distilled water | 98.9990 |
| Comparative Example 12 | Fluoroacrylic carboxylate | 0.001 | 1,2,3-propanetriol | 2.0 | Distilled water | 97.9990 |

**[Table 15]**

| | Surfactant | | Additive | | Distilled water | |
|---|---|---|---|---|---|---|
| | Name | Content (% by weight) | Name | Content (% by weight) | Name | Content (% by weight) |
| Example 76 | Fluoroacrylic carboxylate | 0.001 | 1,2,3,4--Butanetetraol | 0.0000 | Distille | 99.9989 |
| Example 77 | Fluoroacrylic carboxylate | 0.001 | 1,2,3,4-Butanetetraol | 0.0001 | Distilled water | 99.9989 |
| Example 78 | Fluoroacrylic carboxylate | 0.001 | 1,2,3,4-Butanetetraol | 0.001 | Distilled water | 99.9980 |
| Example 11 | Fluoroacrylic carboxylate | 0.001 | 1,2,3,4-Butanetetraol | 0.01 | Distilled water | 99.9890 |
| Example 79 | Fluoroacrylic carboxylate | 0.001 | 1,2,3,4-Butanetetraol | 0.1 | Distilled water | 99.8990 |
| Example 80 | Fluoroacrylic carboxylate | 0.001 | 1,2,3,4-Butanetetraol | 1.0 | Distille d water | 98.9990 |
| Comparative Example 13 | Fluoroacrylic carboxylate | 0.001 | 1,2,3,4-Butanetetraol | 2.0 | Distilled water | 97.9990 |

[Experimental Examples 1 to 80 and Comparative Experimental Examples 1 to 13] Measurements of pattern lifting defect levels, transparency values, contact angles, and surface tension values were performed on silicon wafers on which patterns are formed using the compositions prepared in Examples 1 to 80 and Comparative Examples 1 to 13. The measurements are described as Experimental Examples 1 to 80 and Comparative Experimental Examples 1 to 13. The results of the measurements are shown in Table 16.

### (1) Verification of Pattern Lifting Prevention

After exposure energy and focus were split, among a total of 89 blocks, the number of blocks in which a pattern did not collapse was detected using a critical dimension-scanning electron microscope (CD-SEM, manufactured by Hitachi, Ltd).

### (2) Transparency

Transparency of each of the prepared process liquid composition was checked with the naked eye and was marked as a transparent or opaque process liquid composition.

### (3) Contact Angle and Surface Tension

The surface tension and contact angle of each of the process liquid compositions were measured using a surface tension measuring instrument [K-100, manufactured by KRÜSS GmbH] and a contact angle measuring instrument [DSA-100, manufactured by KRÜSS GmbH].

**[Table 16]**

| | Number of blocks without pattern lifting defects | Transparency | Contact angle | Surface tension |
|---|---|---|---|---|
| Experimental Example 1 | 82 | Transparent | 50 | 28 |
| Experimental Example 2 | 80 | Transparent | 58 | 32 |
| Experimental Example 3 | 79 | Transparent | 54 | 30 |
| Experimental Example 4 | 78 | Transparent | 60 | 32 |
| Experimental Example 5 | 74 | Transparent | 59 | 31 |
| Experimental Example 6 | 75 | Transparent | 61 | 33 |
| Experimental Example 7 | 71 | Transparent | 63 | 41 |
| Experimental Example 8 | 71 | Transparent | 57 | 40 |
| Experimental Example 9 | 72 | Transparent | 59 | 38 |
| Experimental Example 10 | 73 | Transparent | 58 | 35 |
| Experimental Example 11 | 81 | Transparent | 56 | 32 |
| Experimental Example 12 | 79 | Transparent | 59 | 34 |
| Experimental Example 13 | 79 | Transparent | 57 | 30 |
| Experimental Example 14 | 77 | Transparent | 62 | 33 |
| Experimental Example 15 | 74 | Transparent | 61 | 31 |
| Experimental Example 16 | 74 | Transparent | 63 | 34 |
| Experimental Example 17 | 71 | Transparent | 64 | 38 |
| Experimental Example 18 | 70 | Transparent | 57 | 36 |
| Experimental Example 19 | 71 | Transparent | 58 | 35 |
| Experimental Example 20 | 72 | Transparent | 58 | 33 |
| Experimental Example 21 | 67 | Transparent | 63 | 43 |
| Experimental Example 22 | 69 | Transparent | 59 | 34 |
| Experimental Example 23 | 75 | Transparent | 45 | 26 |
| Experimental Example 24 | 74 | Transparent | 40 | 23 |
| Experimental Example 25 | 55 | Transparent | 62 | 45 |
| Experimental Example 26 | 67 | Transparent | 60 | 28 |
| Experimental Example 27 | 74 | Transparent | 55 | 29 |
| Experimental Example 28 | 72 | Transparent | 54 | 27 |
| Experimental Example 29 | 62 | Transparent | 63 | 41 |
| Experimental Example 30 | 66 | Transparent | 57 | 34 |
| Experimental Example 31 | 74 | Transparent | 54 | 26 |
| Experimental Example 32 | 71 | Transparent | 50 | 23 |
| Experimental Example 33 | 64 | Transparent | 64 | 41 |
| Experimental Example 34 | 67 | Transparent | 60 | 35 |
| Experimental Example 35 | 76 | Transparent | 59 | 28 |
| Experimental Example 36 | 74 | Transparent | 52 | 24 |
| Experimental Example 37 | 62 | Transparent | 62 | 40 |
| Experimental Example 38 | 66 | Transparent | 60 | 35 |
| Experimental Example 39 | 71 | Transparent | 57 | 27 |
| Experimental Example 40 | 70 | Transparent | 56 | 23 |
| Experimental Example 41 | 61 | Transparent | 64 | 41 |
| Experimental Example 42 | 69 | Transparent | 61 | 34 |
| Experimental Example 43 | 72 | Transparent | 58 | 25 |
| Experimental Example 44 | 71 | Transparent | 57 | 25 |
| Experimental Example 45 | 54 | Transparent | 63 | 45 |
| Experimental Example 46 | 62 | Transparent | 62 | 39 |
| Experimental Example 47 | 70 | Transparent | 59 | 31 |
| Experimental Example 48 | 67 | Transparent | 57 | 30 |
| Experimental Example 49 | 60 | Transparent | 60 | 43 |
| Experimental Example 50 | 68 | Transparent | 58 | 40 |
| Experimental Example 51 | 70 | Transparent | 54 | 30 |
| Experimental Example 52 | 72 | Transparent | 52 | 27 |
| Experimental Example 53 | 66 | Transparent | 62 | 43 |
| Experimental Example 54 | 71 | Transparent | 60 | 37 |
| Experimental Example 55 | 76 | Transparent | 57 | 30 |
| Experimental Example 56 | 74 | Transparent | 52 | 28 |
| Experimental Example 57 | 64 | Transparent | 63 | 43 |
| Experimental Example 58 | 70 | Transparent | 57 | 34 |
| Experimental Example 59 | 73 | Transparent | 56 | 25 |
| Experimental Example 60 | 72 | Transparent | 53 | 23 |
| Experimental Example 61 | 81 | Transparent | 53 | 33 |
| Experimental Example 62 | 79 | Transparent | 58 | 33 |
| Experimental Example 63 | 79 | Transparent | 55 | 34 |
| Experimental Example 64 | 77 | Transparent | 61 | 33 |
| Experimental Example 65 | 74 | Transparent | 60 | 31 |
| Experimental Example 66 | 74 | Transparent | 61 | 34 |
| Experimental Example 67 | 72 | Transparent | 63 | 40 |
| Experimental Example 68 | 70 | Transparent | 55 | 39 |
| Experimental Example 69 | 70 | Transparent | 56 | 37 |
| Experimental Example 70 | 73 | Transparent | 58 | 34 |
| Experimental Example 71 | 64 | Transparent | 44 | 21 |
| Experimental Example 72 | 71 | Transparent | 45 | 23 |
| Experimental Example 73 | 78 | Transparent | 48 | 26 |
| Experimental Example 74 | 77 | Transparent | 52 | 31 |
| Experimental Example 75 | 71 | Transparent | 55 | 33 |
| Experimental Example 76 | 61 | Transparent | 49 | 25 |
| Experimental Example 77 | 70 | Transparent | 50 | 28 |
| Experimental Example 78 | 78 | Transparent | 52 | 30 |
| Experimental Example 79 | 77 | Transparent | 54 | 34 |
| Experimental Example 80 | 70 | Transparent | 58 | 35 |
| Comparative Test Example 1 | 45 | Transparent | 87 | 71 |
| Comparative Test Example 2 | 55 | Opaque | 40 | 18 |
| Comparative Test Example 3 | 52 | Opaque | 54 | 22 |
| Comparative Test Example 4 | 50 | Opaque | 49 | 20 |
| Comparative Test Example 5 | 49 | Opaque | 53 | 19 |
| Comparative Test Example 6 | 51 | Opaque | 52 | 21 |
| Comparative Test Example 7 | 52 | Opaque | 57 | 23 |
| Comparative Test Example 8 | 49 | Opaque | 59 | 26 |
| Comparative Test Example 9 | 48 | Opaque | 51 | 41 |
| Comparative Test Example 10 | 50 | Opaque | 54 | 27 |
| Comparative Test Example 11 | 53 | Opaque | 53 | 24 |
| Comparative Test Example 12 | 60 | Opaque | 59 | 37 |
| Comparative Test Example 13 | 59 | Opaque | 60 | 38 |

From the comparison of Experimental examples 1 to 80 with Comparative Experimental Examples 1 to 13 on the basis of the result of conducting much research over a long period of time, it could be seen that, when the number of blocks in which a pattern did not collapse was 50 or greater and the composition exhibited a transparent property, a more improved result was obtained. That is, it was verified that when the compositions as in Experimental Examples 1 to 80 described below were used, the effect of reducing the pattern lifting defects was improved compared to the cases where the compositions as in Comparative Experimental Examples 1 to 13 were used. Each of the compositions as in Experimental Examples 1 to 80 included: 0.00001% to 0.1% by weight of a fluorine-based surfactant selected from the following, 0.00001% to 1.0% by weight of a C3 to C10 triol derivative alone selected from the following, a C4 to C14 tetraol alone selected from the following, or a mixture thereof; and 98.9% to 99.99998% of water, in which the fluorine-based surfactant were selected from fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, and perfluorianted sulfonate; the C3 to C10 triol derivative was selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof; and the C4 to C14 tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

In addition, among the compositions corresponding to Experimental Examples 1 to 80, the composition containing 0.0001% to 0.1% by weight of a fluorine-based surfactant selected from the following, 0.00001% to 1.0% by weight of a C3 to C10 triol derivative alone selected from the following, a C4 to C14 tetraol alone selected from the following, or a mixture thereof; and the remaining proportion of water improved the effect of reducing the pattern lifting defects compared to Comparative Experimental Examples 1 to 13, in which the fluorine-based surfactant was selected from fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, and perfluorianted sulfonate; the C3 to C10 triol derivative was selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene -1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof; and the C4 to C14 tetraol derivative was selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2, 5,6-hexanetetraol, 1,3,4,5-hexanetetraol, 1,3,4,6-hexanetetraol, 2,3,4,5-hexanetetraol, 1,2,6, 7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

Among the compositions as in Experimental Examples 1 to 80, the composition including 0.001% to 0.1% by weight of a fluorine-based surfactant selected from the following, 0.00001% to 1.0% by weight of a C3 to C10 triol derivative alone selected from the following, a C4 to C14 tetraol alone selected from the following, or a mixture thereof; and the remaining proportion of water improved the effect of reducing the pattern lifting defects compared to Comparative Experimental Examples 1 to 13, in which the fluorine-based surfactant were selected from fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, and perfluorianted sulfonate; the C3 to C10 triol derivative was selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof; and the C4 to C14 tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6, 7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

In addition, among the compositions corresponding to Experimental Examples 1 to 80, the composition containing 0.001% to 0.1% by weight of a fluorine-based surfactant selected from the following, 0.0001% to 1.0% by weight of a C3 to C10 triol derivative alone selected from the following, a C4 to C14 tetraol alone selected from the following, or a mixture thereof; and the remaining proportion of water improved the effect of reducing the pattern lifting defects compared to Comparative Experimental Examples 1 to 13, in which the fluorine-based surfactant was selected from fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, and perfluorianted sulfonate; the C3 to C10 triol derivative was selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene -1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof; and the C4 to C14 tetraol derivative was selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6, 7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

In addition, among the compositions corresponding to Experimental Examples 1 to 80, the composition containing 0.001% to 0.1% by weight of a fluorine-based surfactant selected from the following, 0.001% to 1.0% by weight of a C3 to C10 triol derivative alone selected from the following, a C4 to C14 tetraol alone selected from the following, or a mixture thereof; and the remaining proportion of water improved the effect of reducing the pattern lifting defects compared to Comparative Experimental Examples 1 to 13, in which the fluorine-based surfactant was selected from fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, and perfluorianted sulfonate; the C3 to C10 triol derivative was selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof; and the C4 to C14 tetraol derivative was selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

As shown in FIG. 1, the result of measuring the collapse level of the photoresist pattern formed in Example 1 for evaluation was that the number of blocks in which the pattern did not collapse was 82, thereby having exhibited the best effect.

As shown in FIG. 2, the result of measuring the collapse level of the photoresist pattern as in *Comparative Experimental Example 1 for evaluation was that the number of blocks in which the pattern did not collapse was 45.

The specific aspects of the present invention are described in detail above. It would be apparent to a person of ordinary skill in the art to which the present invention pertains that this specific description is only for the desired embodiments and do not impose any limitation on the scope of the present invention. Therefore, a substantial scope and a scope equivalent thereto must be defined by the following claims.

## Claims

1. A process liquid composition for alleviating a lifting defect level of a photoresist pattern, the photoresist pattern having hydrophobicity represented by a contact angle of 75° or greater of a surface thereof with respect to water in a photoresist patterning process, the composition comprising a surfactant and having a surface tension of 45 mN/m or less and a contact angle of 65° or smaller.

2. The composition according to claim 1, comprising:
0.00001% to 0.1% by weight of a fluorine-based surfactant;
0.00001% to 1.0% by weight of a triol derivative, a tetraol derivative, or a mixture thereof; and the remaining proportion of water.

3. The composition according to claim 2, comprising: 0.0001% to 0.1% by weight of a fluorine-based surfactant; 0.00001% to 1.0% by weight of a triol derivative, a tetraol derivative, or a mixture thereof; and the remaining proportion of water.

4. The composition according to claim 3, comprising: 0.001% to 0.1% by weight of a fluorine-based surfactant; 0.00001% to 1.0% by weight of a triol derivative, a tetraol derivative, or a mixture thereof; and the remaining proportion of water.

5. The composition according to claim 4, comprising: 0.001% to 0.1% by weight of the fluorine-based surfactant; 0.0001% to 1.0% by weight of a triol derivative, a tetraol derivative, or a mixture thereof; and the remaining proportion of water.

6. The composition according to claim 5, comprising: 0.001% to 0.1% by weight of the fluorine-based surfactant; 0.001% to 1.0% by weight of a triol derivative, a tetraol derivative, or a mixture thereof; and the remaining proportion of water.

7. The composition according to claim 2, wherein the fluorine-based surfactant is selected from the group consisting of fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, perfluorianted sulfonate, and mixtures thereof.

8. The composition according to claim 2, wherein the triol derivative is a C3 to C10 triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and
wherein the tetraol derivative is a C4 to C14 tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

9. A method of forming a photoresist pattern, the method comprising the steps of: (a) applying photoresist on a semiconductor substrate to form a photoresist film; (b) exposing the photoresist film to light and developing the photoresist film to form a photoresist pattern; and (c) cleaning the photoresist pattern with the composition of any one of claims 1 to 8.
